# EUROPEAN PATENT SPECIFICATION

(11) **EP 3 101 438 B1**
(45) Date of publication and mention of the grant of the patent: **30.12.2020**
(21) Application number: 16167532.7
(22) Date of filing: 28.04.2016
(51) Int. Cl.: G01R 31/317, H02M 1/00, H03L 1/00

(54) **JITTER CONTROL CIRCUIT WITHIN CHIP AND ASSOCIATED JITTER CONTROL METHOD**
JITTERSTEUERUNGSSCHALTUNG IN EINEM CHIP UND ZUGEHÖRIGES JITTERSTEUERUNGSVERFAHREN
CIRCUIT DE COMMANDE DE GIGUE DANS UNE PUCE ET PROCÉDÉ DE COMMANDE DE GIGUE ASSOCIÉ

(30) Priority: 05.06.2015 US 201562171584 P; 06.04.2016 US 201615091588
(43) Date of publication of application: 07.12.2016
(73) Proprietor: MediaTek Inc., Hsin-Chu 300 (TW)
(72) Inventor: CHEN, Shang-Pin, Zhubei City, Hsinchu County 302 (TW); LEE, Sheng-Feng, Hsinchu City 300 (TW)
(74) Representative: Hoefer & Partner Patentanwälte mbB

(56) References cited:
- US-A1- 2006 022 744
- US-A1- 2008 074 200
- US-A1- 2014 301 118
- US-B1- 8 836 384

## Description

### Background

For a chip supplied by an external supply voltage, the external supply voltage is inputted into the chip via a power delivery network (PDN) including many connections such as printed circuit board (PCB) routing, substrate traces, wire bond, input/output pad and internal metal layer etc.. The PDN can be modeled as a RLC circuit consisting of a resistor, an inductor and a capacitor, and impedance of the PDN varies with a frequency thereon. In addition, because the chip also includes a plurality of drivers that may sink currents from the PDN, the current generated by the drivers and the impedance of the PDN form a supply voltage noise on the PDN. This supply voltage noise may cause a clock generator within the chip to generate a clock with serious jitter. Therefore, providing a scheme to reduce this power supply induced jitter (PSIJ) is an important topic.

US8,836,384B1 discloses systems and methods for reducing jitter due to power supply noise in an integrated circuit by drawing additional current.

### Summary

It is therefore an objective of the present invention to provide a Jitter control circuit and associated jitter control method to effectively reduce the power supply induced jitter, to solve the above-mentioned problem.

This is achieved by a jitter control circuit according to claim 1, a jitter control method according to claim 5, and a jitter control circuit to claim 9. The dependent claims pertain to corresponding further developments and improvements.

As will be seen more clearly from the detailed description following below, a jitter control circuit within a chip comprises an adaptive PDN, a current generator and a jitter generator. The adaptive PDN is capable of being controlled/modulated to provide difference impedances. The current generator is coupled to the adaptive PDN, and is arranged for receiving a supply voltage provided by the adaptive PDN and generating currents with different patterns. The jitter generator is coupled to the adaptive PDN, and is arranged for generating a plurality of jitters corresponding to the currents with different patterns, respectively, according to the supply voltage provided by the adaptive PDN.

As will be seen more clearly from the detailed description following below, a jitter control method comprises: providing an adaptive PDN capable of being controlled/modulated to provide difference impedances; receiving a supply voltage provided by the adaptive PDN and generating currents with different patterns; and generating a plurality of jitters corresponding to the currents with different patterns, respectively, according to the supply voltage provided by the adaptive PDN.

As will be seen more clearly from the detailed description following below, a jitter control circuit within a chip comprises an adaptive PDN, a current generator and a controller. The adaptive PDN is capable of being controlled/modulated to provide difference impedances. The current generator is coupled to the adaptive PDN, and is arranged for receiving a supply voltage provided by the adaptive PDN and generating a current. The controller is coupled to the adaptive PDN and the current generator, and is arranged for controlling the impedance of the adaptive PDN according to a pattern of the current generated by the current generator.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a jitter control circuit according to one embodiment of the present invention.
FIG. 2 shows a diagram illustrating a generation of the jitter.
FIG. 3 is a flowchart of a jitter control method according to one embodiment of the present invention.
FIG. 4 is a diagram illustrating an adaptive PDN according to one embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ..." The terms "couple" and "couples" are intended to mean either an indirect or a direct electrical connection. Thus, if a first device couples to a second device, that connection may be through a direct electrical connection, or through an indirect electrical connection via other devices and connections.

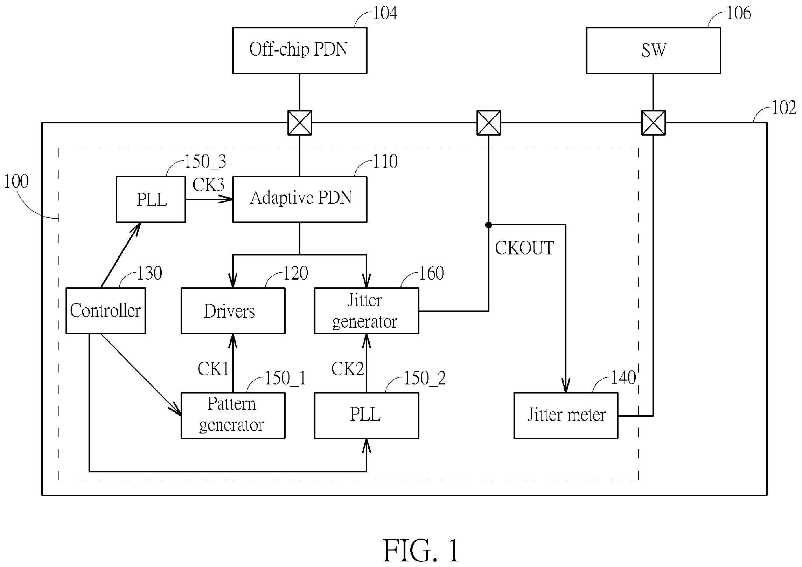

Please refer to FIG. 1, which is a diagram illustrating a jitter control circuit 100 according to one embodiment of the present invention. As shown in FIG. 1, the jitter control circuit 100 is within a chip 102, and the jitter control circuit 100 comprises an adaptive power delivery network (PDN) 110, a current generator (in this embodiment, the current generator is implemented by a plurality of drivers 120), a controller 130, a jitter meter 140, a pattern generator 150_1 (in this embodiment, the pattern generator 150_1 may be implemented by a phase-locked loop (PLL)), two PLL 150_2 and 150_3 and a jitter generator 160. In addition, the adaptive PDN 110 is coupled to an off-chip PDN 104, and the jitter meter 140 is coupled to a software side 106.

In this embodiment, the off-chip PDN 104 is coupled to an external power supply, and is arranged to provide a supply voltage to the adaptive PDN 110 of the chip 102, and the adaptive PDN 110 provides the received supply voltage to the drivers 120 and the jitter generator 160 and other elements required using the supply voltage. The drivers 120 can be any functional circuit elements that may provide or sink current according to the supply voltage. The jitter generator 160 is arranged to output an output clock CKOUT based on a clock CK2 provided by the PLL 150_2 and the supply voltage. The pattern generator 1 50_1 is arranged to provide a clock CK1 to the drivers 120 to control the pattern of the current (hereinafter, the frequency serves as an example of the pattern) generated by the drivers 120; and the PLL 150_3 is arranged to generate a clock CK3 to control the frequency of the adaptive PDN 110 to determine the impedance of the adaptive PDN 110.

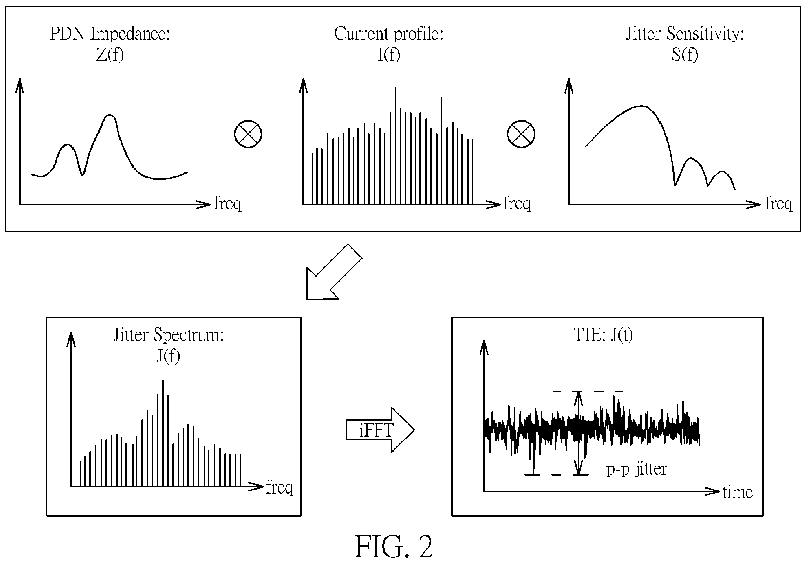

In FIG. 1, a jitter level of the output clock CKOUT is determined based on the impedance of the off-chip PDN 104, the adaptive PDN 110, the frequency of the current of the drivers 120 and the sensitivity of the clock CK2. In detail, refer to FIG. 2, the jitter J(f) of the output clock CKOUT can be obtained by the product of the impedance of the off-chip PDN 104 and the adaptive PDN 110 (Z(f)), the current I(f) of the drivers 120 and the sensitivity S(f) of the clock CK2, and FIG. 2 shows a diagram of the peak-to-peak jitter (p-p jitter) when the jitter J(f) is transformed to time domain by using iFFT (inverse fast Fourier transform).

The jitter control circuit 100 may provide different operations during an off-line period and an on-line period. During an off-line period (e.g. in the production line), the jitter control circuit 100 is arranged to control frequencies of the pattern generator 150_1 and the PLL 150_3 to find some particular combinations of the frequencies of the pattern generator 150_1 and the PLL 150_3, where the particular combinations may correspond to serious jitter of an output clock CKOUT outputted by the jitter generator 160, the slight jitter of an output clock CKOUT outputted by the jitter generator 160, and/or any other required jitter information. Then, the particular combinations of the frequencies of the pattern generator 150_1 and the PLL 150_3 can be built into a look-up table, and the look-up table is stored in the chip 102 for further use. When the chip 102 is used in the on-line period, the controller 130 may refer to the look-up table to adjust the impedance of the adaptive PDN 110 according to the frequency of the current generated by the drivers 120 and/or other drivers, so as to lower the jitter of the output clock CKOUT outputted by the jitter generator 160 or to lower the jitter of the other clock(s). Detailed descriptions of the operations of the jitter control circuit 100 are provided below.

During the off-line period, first, the controller 130 controls the PLL 150_2 to output the clock CK2 with a fixed frequency, then the controller 130 controls the pattern generator 150_1 to output the clock CK1 with different frequencies to the drivers 120 to make the current have different frequencies respectively, and the controller 130 controls the PLL 1 50_3 to output the clock CK3 for modulating the adaptive PDN 110 to have different frequencies to have different values of impedance respectively. For every combination of the frequencies of the clocks CK1 and CK3 (i.e. the every combination of the frequencies of the adaptive PDN 110 and the current), a corresponding supply voltage noise is generated on the metal routing within the chip 102, causing different jitter level of the output clock CKOUT. Then, the jitter meter 140 determines the jitter level of the output clock CKOUT corresponding to every combination of the frequencies of the clocks CK1 and CK3 to generate a plurality of determining results, and sends the determining results to the software side 106.

In one embodiment, initially, the controller 130 may control the PLL 150_3 to output the clock CK3 to modulate the adaptive PDN 110 to have a specific frequency to have a specific impedance, then the controller 130 controls the pattern generator 1 50_1 to output the clock CK1 with different frequencies to the drivers 120 to make the current to have different frequencies, respectively, and the jitter meter 140 determines the jitter levels of the output clock CKOUT corresponding to the different frequencies of clock CK1 (i.e. different frequencies of the current) respectively. Then, for a portion of the frequencies of the clock CK1 whose corresponding jitters are greater than a threshold (that is the serious jitter may occur when the clock CK1 has such frequencies), the controller 130 controls the PLL 150_3 to output the clock CK3 to modulate the adaptive PDN 110 to have the different impedances, respectively, and the jitter meter 140 determines the jitter levels of the output clock CKOUT corresponding to the combinations of the current with the portion of the frequencies and the different frequencies of the adaptive PDN 110, respectively.

For example, if the jitter meter 140 determines that the serious jitter occurs when the PLL 150_3 outputs the clock CK3 with the frequency 1 GHz and the pattern generator 150_1 outputs the clock CK1 with the frequencies 300 MHz and 1 GHz, the controller 130 may fix the clock CK1 with 300 MHz and control the PLL 150_3 to output the clock CK3 to have many different frequencies to find a combination of the frequencies of the clocks CK1 and CK3 corresponding to a slight jitter, for example the clock CK3 with 2 GHz; and the controller 130 may further fix the clock CK1 with 1 GHz and control the PLL 1 50_3 to output the clock CK3 to have many different frequencies to find a combination of the frequencies of the clocks CK1 and CK3 corresponding to a slight jitter, for example the clock CK3 with 1.5 GHz. Then, the look-up table may record that the combination (CK1, CK3) = (300 MHz, 1 GHz) and (CK1, CK3) = (1 GHz, 1 GHz) may have serious jitter, and also record that the combination (CK1, CK3) = (300 MHz, 2 GHz) and (CK1, CK3) = (1 GHz, 1.5 GHz) may have slighter jitter.

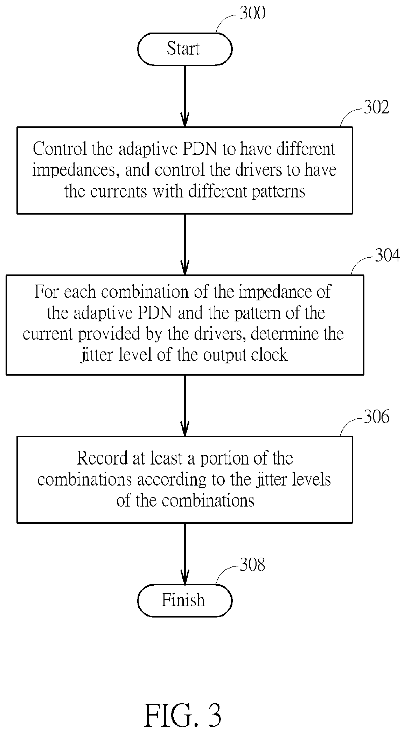

The operations of the jitter control circuit 100 during the off-line period are summarized as shown in FIG. 3. In FIG. 3, the flow of the jitter control method during the off-line period is as follows:
Step 300: the flow starts.
Step 302: control the adaptive PDN 110 to have different impedances, and control the drivers 120 to have the current with different frequencies.
Step 304: for each combination of the impedance of the adaptive PDN 110 and the frequency of the current provided by the drivers 120, determine the jitter level of the output clock CKOUT.
Step 306: record at least a portion of the combinations according to the jitter levels of the combinations.
Step 308: the flow finishes.

When the jitter control circuit 100 is operated during the on-line period, for example the chip 102 is built in an electronic device such as a cell phone, and the electronic device is in use, the controller 130 may refer to the look-up table to adjust the impedance of the adaptive PDN 110 according to the frequency of the current generated by the drivers 120 and/or other drivers, so as to lower the jitter of the output clock CKOUT or the other clock signals. For example, assuming that the look-up table records that the combination (CK1, CK3) = (300 MHz, 1 GHz) and (CK1, CK3) = (1 GHz, 1 GHz) may have serious jitter and records that the combination (CK1, CK3) = (300 MHz, 2 GHz) and (CK1, CK3) = (1 GHz, 1.5 GHz) may have slighter jitter, when the controller 130 detects that the current of the drivers within the chip 102 has the frequency close to or equal to 300MHz, the controller 130 detects whether the impedance/frequency of the adaptive PDN 110 causes a clock jitter while the frequency of the current of the drivers is 300 MHz. If the controller 130 determines that the impedance/frequency of the adaptive PDN 110 causes the serious clock jitter (e.g. the frequency of the adaptive PDN 110 is 1 GHz), the controller 130 will search for an appropriate frequency of the adaptive PDN 110 in the look-up table to lower the clock jitter, for example, 2 GHz, and controls the PLL 150_3 to output the clock CK3 with the frequency 2 GHz. In addition, if the controller 130 determines that the impedance/frequency of the adaptive PDN 110 does not cause the serious clock jitter (e.g. the frequency of the adaptive PDN 110 is close to 2 GHz), the adaptive PDN 110 will not adjust the frequency of the clock CK3.

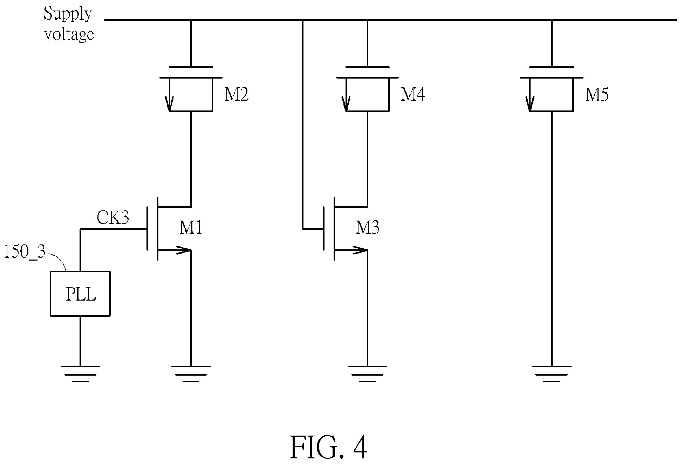

In FIG. 1, the drivers 120 can be implemented by a simultaneous Switching Output (SSO) noise generator for generating the current noise according to the supply voltage provided by the adaptive PDN 110, the jitter generator 160 can be implemented by D-type flip-flops supplied by the supply voltage provided by the adaptive PDN 110 to receive the clock CK2 to generate the output clock CKOUT, and the adaptive PDN 110 can be implemented by any type of circuits such as switched capacitors or any other RLC circuit whose impedance is varied with the frequency of the signal applied thereon, without limitations of the present invention. For example, FIG. 4 is a diagram illustrating the adaptive PDN 110 according to one embodiment of the present invention. In FIG. 4, the adaptive PDN 110 comprises five transistors M1-M5, and is modulated by the clock CK3.

Briefly summarized, in the jitter control circuit and jitter control method of the present invention, the adaptive PDN 110 is provided to adjust its own impedance to lower the clock jitter within the chip 102, and the look-up table for adjusting the impedance of the adaptive PDN 110 is built based on the jitters generated based on the internal circuits within the chip 102. Therefore, the information of the look-up table is more reliable, and the impedance of the adaptive PDN 110 can be controlled to effectively lower the clock jitter.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A jitter control circuit (100) within a chip (102), comprising:
an adaptive power delivery network (PDN) (110) configured to provide a supply voltage, capable of being controlled/modulated to provide different impedances;
a current generator (120), coupled to the adaptive PDN (110), configured to receive the supply voltage provided by the adaptive PDN (110) and to generate currents with different patterns; and
a jitter generator (160), coupled to the adaptive PDN (110), configured to generate a plurality of jitters corresponding to the currents with different patterns, respectively, according to the supply voltage provided by the adaptive PDN (110),
**characterized in that**
for a portion of the patterns of the currents whose corresponding jitters are greater than a threshold, the adaptive PDN (110) is arranged to be controlled/modulated to have different frequencies to have the different impedances, respectively, and
the jitter generator (160) is configured to generate the plurality of jitters corresponding to the currents with the portion of the patterns and the different frequencies of the adaptive PDN (110), respectively, according to the supply voltage provided by the adaptive PDN (110),
wherein a look-up table is generated based on the plurality of jitters corresponding to the currents with the portion of the patterns and the different frequencies of the adaptive PDN (110), respectively, during an off-line period, and the look-up table is stored in the chip (102), said look-up table comprises a plurality of combinations of the impedances of the adaptive PDN (110) and the patterns of the current generated by the current generator (120), and a plurality of jitter levels corresponding to the combinations, respectively.

2. The jitter control circuit (100) of claim 1, **characterized in that**
the adaptive PDN (110) is arranged to be controlled/modulated to have different frequencies to have the different impedances, respectively; and
the jitter generator (160) is configured to generate the plurality of jitters corresponding to the currents with different patterns and the different frequencies of the adaptive PDN (110), respectively, according to the supply voltage provided by the adaptive PDN (110).

3. The jitter control circuit (100) of claim 1, **characterized in that** further comprising:
a controller (130), coupled to the current generator (120), configured to refer to the look-up table to adjust the impedance of the adaptive PDN (110) according the pattern of the current generated by the current generator (120) or a pattern of a current generated by other current generator(s), so as to lower a jitter of a clock within the chip (102).

4. The jitter control circuit (100) of claim 1, **characterized in that** further comprising:
a controller (130), coupled to the current generator (120), configured to refer to a look-up table to adjust the impedance of the adaptive PDN (110) according the pattern of the current generated by the current generator (120) or a pattern of a current generated by other current generator(s), so as to lower a jitter of a clock within the chip (102);
wherein the look-up table comprises a plurality of combinations of the impedances of the adaptive PDN (110) and the patterns of the current generated by the current generator (120), and a plurality of jitter levels corresponding to the combinations, respectively.

5. A jitter control method, comprising:
providing an adaptive power delivery network (PDN) (110) for providing a supply voltage, capable of being controlled/modulated to provide different impedances;
receiving the supply voltage provided by the adaptive PDN (110) and generating currents with different patterns; and
generating a plurality of jitters corresponding to the currents with different patterns, respectively, according to the supply voltage provided by the adaptive PDN (110), **characterized by**:
for a portion of the patterns of the currents whose corresponding jitters are greater than a threshold, controlling/modulating the adaptive PDN (110) to provide different frequencies to provide the different impedances, respectively;
wherein the step of generating the plurality of jitters comprises generating the plurality of jitters corresponding to the currents with the portion of the patterns and the different frequencies of the adaptive PDN (110), respectively, according to the supply voltage provided by the adaptive PDN (110);
generating a look-up table based on the plurality of jitters corresponding to the currents with the portion of the patterns and the different frequencies of the adaptive PDN (110), respectively, during an off-line period; said look-up table comprises a plurality of combinations of the impedances of the adaptive PDN (110) and the patterns of the current generated by the current generator (120), and a plurality of jitter levels corresponding to the combinations, respectively; and
storing the look-up table.

6. The jitter control method of claim 5, **characterized in that** further comprising:
controlling/modulating the adaptive PDN (110) to provide different frequencies to provide the different impedances, respectively; and
the step of generating the plurality of jitters comprises:
generating the plurality of jitters corresponding to the currents with different patterns and the different frequencies of the adaptive PDN (110), respectively, according to the supply voltage provided by the adaptive PDN (110).

7. The jitter control method of claim 5, **characterized in that** further comprising:
referring to the look-up table to adjust the impedance of the adaptive PDN (110) according the pattern of the current or a pattern of a current generated by other current generator(s), so as to lower a jitter of a clock within a chip (102).

8. The jitter control method of claim 5, **characterized in that** further comprising:
referring to a look-up table to adjust the impedance of the adaptive PDN (110) according the pattern of the current or a pattern of a current generated by other current generator(s), so as to lower a jitter of a clock within a chip (102);
wherein the look-up table comprises a plurality of combinations of the impedances of the adaptive PDN (110) and the patterns of the current, and a plurality of jitter levels corresponding to the combinations, respectively.

9. A jitter control circuit (100) within a chip (102), **characterized by**:
an adaptive power delivery network (PDN) (110), configured to provide a supply voltage, capable of being controlled/modulated to provide different impedances;
a current generator (120), coupled to the adaptive PDN (110), configured toreceive the supply voltage provided by the adaptive PDN (110) and to generate a current; and
a controller (130), coupled to the adaptive PDN (110) and the current generator (120), , configured to control the impedance of the adaptive PDN (110) according to a pattern of the current generated by the current generator (120),
**characterized in that**
the controller (130) is configured to refer to a look-up table to adjust the impedance of the adaptive PDN (110) according the pattern of the current generated by the current generator (120), wherein the look-up table comprises a plurality of combinations of the impedances of the adaptive PDN (110) and the patterns of the current generated by the current generator (120), and a plurality of jitter levels corresponding to the combinations, respectively.

10. The jitter control circuit (100) of claim 9, **characterized in that** the controller (130) is configured to control the adaptive PDN (110) to provide a different frequency to adjust the impedance of the adaptive PDN (110) according to the pattern of the current generated by the current generator (120).

## Patentansprüche

1. Jitter-Steuerungsschaltung (100) innerhalb eines Chips (102), aufweisend:
ein adaptives Energieversorgungsnetzwerk (PDN) (110), eingerichtet, eine Versorgungsspannung bereitzustellen, dazu geeignet, gesteuert/moduliert zu werden, um unterschiedliche Impedanzen bereitzustellen;
einen Stromerzeuger (120), der mit dem adaptiven PDN (110) verbunden ist, eingerichtet, die Versorgungsspannung zu empfangen, die durch das adaptive PDN (110) bereitgestellt wird, und Ströme mit unterschiedlichen Profilen zu erzeugen; und
einen Jitter-Generator (160), der mit dem adaptiven PDN (110) verbunden ist, eingerichtet, eine Mehrzahl von Jittern, die jeweils zu den Strömen mit unterschiedlichen Profilen korrespondieren, gemäß der Versorgungsspannung zu generieren, die durch das adaptive PDN (110) bereitgestellt wird,
**dadurch gekennzeichnet, dass**
für einen Teil der Profile der Ströme, deren korrespondierende Jitter größer sind als ein Schwellenwert, das adaptive PDN (110) ausgelegt ist, so gesteuert/moduliert zu werden, dass es unterschiedliche Frequenzen aufweist, dass es jeweils die unterschiedlichen Impedanzen aufweist, und
der Jitter-Generator (160) eingerichtet ist, die Mehrzahl von Jittern, die jeweils zu den Strömen mit dem Teil der Profile und den unterschiedlichen Frequenzen des adaptiven PDNs (110) korrespondieren, gemäß der Versorgungsspannung zu generieren, die durch das PDN (110) bereitgestellt wird,
wobei eine Nachschlagtabelle basierend auf der Mehrzahl von Jittern, die jeweils zu den Strömen mit dem Teil der Profile und den unterschiedlichen Frequenzen des adaptiven PDNs (110) korrespondieren, während einer Offline-Periode generiert wird, und die Nachschlagtabelle in dem Chip (102) gespeichert wird, die Nachschlagtabelle eine Mehrzahl von Kombinationen der Impedanzen des adaptiven PDNs (110) und der Profile des Stroms, der durch den Stromerzeuger (120) erzeugt wird, aufweist, und eine Mehrzahl von Jitter-Pegeln jeweils zu den Kombinationen korrespondiert.

2. Jitter-Steuerungsschaltung (100) gemäß Anspruch 1, **dadurch gekennzeichnet, dass**
das adaptive PDN (110) ausgelegt ist, so gesteuert/moduliert zu werden, dass es unterschiedliche Frequenzen aufweist, dass es jeweils unterschiedliche Impedanzen aufweist; und
der Jitter-Generator (160) eingerichtet ist, die Mehrzahl von Jittern, die jeweils zu den Strömen mit unterschiedlichen Profilen und den unterschiedlichen Frequenzen des adaptiven PDNs (110) korrespondieren, gemäß der Versorgungsspannung zu generieren, die durch das adaptive PDN (110) bereitgestellt wird.

3. Jitter-Steuerungsschaltung (100) gemäß Anspruch 1, **dadurch gekennzeichnet, dass** sie weiter aufweist:
eine Steuerung (130), die mit dem Stromerzeuger (120) verbunden ist, eingerichtet, sich auf die Nachschlagtabelle zu beziehen, um die Impedanz des adaptiven PDNs (110) gemäß den Profilen des Stroms, der durch den Stromerzeuger (120) erzeugt wird, oder einem Profil eines Stroms, der durch einen anderen / andere Stromerzeuger erzeugt wird, einzustellen, um so einen Jitter eines Takts innerhalb des Chips (102) zu verringern.

4. Jitter-Steuerungsschaltung (100) gemäß Anspruch 1, **dadurch gekennzeichnet, dass** sie weiter aufweist:
eine Steuerung (130), die mit dem Stromerzeuger (120) verbunden ist, eingerichtet, sich auf eine Nachschlagtabelle zu beziehen, um die Impedanz des adaptiven PDNs (110) gemäß dem Profil des Stroms, der durch den Stromerzeuger (120) erzeugt wird, oder einem Profil eines Stroms, der durch einen anderen / andere Stromerzeuger erzeugt wird, einzustellen, um so einen Jitter eines Takts innerhalb des Chips (102) zu verringern;
wobei die Nachschlagtabelle eine Mehrzahl von Kombinationen der Impedanzen des adaptiven PDNs (110) und den Profilen des Stroms, der durch den Stromerzeuger (120) erzeugt wird, und eine Mehrzahl von Jitter-Pegeln, die jeweils zu den Kombinationen korrespondieren, aufweist.

5. Jitter-Steuerungsverfahren, umfassend:
Bereitstellen eines adaptiven Energieversorgungsnetzwerks (PDN) (110) zum Bereitstellen einer Versorgungsspannung, dazu geeignet, gesteuert/moduliert zu werden, um unterschiedliche Impedanzen bereitzustellen;
Empfangen der Versorgungsspannung, die durch das adaptive PDN (110) bereitgestellt wird, und Erzeugen von Strömen mit unterschiedlichen Profilen; und
Generieren einer Mehrzahl von Jittern, die jeweils zu den Strömen mit unterschiedlichen Profilen korrespondieren, gemäß der Versorgungsspannung, die durch das adaptive PDN (110) bereitgestellt wird,
**gekennzeichnet durch**:
für einen Teil der Profile der Ströme, deren korrespondierende Jitter größer sind als ein Schwellenwert, Steuern/Modulieren des adaptiven PDNs (110), sodass es unterschiedliche Frequenzen bereitstellt, um jeweils die unterschiedlichen Impedanzen bereitzustellen;
wobei der Schritt des Generierens der Mehrzahl von Jittern ein Generieren der Mehrzahl von Jittern umfasst, die jeweils zu den Strömen mit dem Teil der Profile und den unterschiedlichen Frequenzen des adaptiven PDNs (110) korrespondieren, gemäß der Versorgungsspannung, die durch das adaptive PDN (110) bereitgestellt wird;
Generieren einer Nachschlagtabelle basierend auf der Mehrzahl von Jittern, die jeweils zu den Strömen mit dem Teil der Profile und den unterschiedlichen Frequenzen des adaptiven PDNs (110) korrespondieren, während einer Offline-Periode; wobei die Nachschlagtabelle eine Mehrzahl von Kombinationen der Impedanzen des adaptiven PDNs (110) und der Profile des Stroms, der durch den Stromerzeuger (120) erzeugt wird, und eine Mehrzahl von Jitter-Pegeln, die jeweils zu den Kombinationen korrespondieren, aufweist; und
Speichern der Nachschlagtabelle.

6. Jitter-Steuerungsverfahren gemäß Anspruch 5, **dadurch gekennzeichnet, dass** es weiter umfasst:
Steuern/Modulieren des adaptiven PDNs (110), sodass es unterschiedliche Frequenzen bereitstellt, um jeweils die unterschiedlichen Impedanzen bereitzustellen; und
der Schritt des Generierens der Mehrzahl von Jittern umfasst:
Generieren der Mehrzahl von Jittern, die jeweils zu den Strömen mit unterschiedlichen Profilen und den unterschiedlichen Frequenzen des adaptiven PDNs (110) korrespondieren, gemäß der Versorgungsspannung, die durch das adaptive PDN (110) bereitgestellt wird.

7. Jitter-Steuerungsverfahren gemäß Anspruch 5, **dadurch gekennzeichnet, dass** es weiter umfasst:
Bezugnehmen auf die Nachschlagtabelle, um die Impedanz des adaptiven PDNs (110) gemäß dem Profil des Stroms oder einem Profil eines Stroms, der durch einen anderen / andere Stromerzeuger generiert wird, einzustellen, um so einen Jitter eines Takts innerhalb eines Chips (102) zu verringern.

8. Jitter-Steuerungsverfahren gemäß Anspruch 5, **dadurch gekennzeichnet, dass** es weiter umfasst:
Bezugnehmen auf eine Nachschlagtabelle, um die Impedanz des adaptiven PDNs (110) gemäß dem Profil des Stroms oder einem Profil eines Stroms, der durch einen anderen / andere Stromerzeuger erzeugt wird, einzustellen, um so einen Jitter eines Takts innerhalb eines Chips (102) zu verringern;
wobei die Nachschlagtabelle eine Mehrzahl von Kombinationen der Impedanzen des adaptiven PDNs (110) und den Profilen des Stroms, und eine Mehrzahl von Jitter-Pegeln, die jeweils zu den Kombinationen korrespondieren, aufweist.

9. Jitter-Steuerungsschaltung (100) innerhalb eines Chips (102), **gekennzeichnet durch**:
ein adaptives Energieversorgungsnetzwerk (PDN) (110), eingerichtet, eine Versorgungsspannung bereitzustellen, dazu geeignet, gesteuert/moduliert zu werden, um unterschiedliche Impedanzen bereitzustellen;
einen Stromerzeuger (120), der mit dem adaptiven PDN (110) verbunden ist, eingerichtet, die Versorgungsspannung zu empfangen, die durch das adaptive PDN (110) bereitgestellt wird, und einen Strom zu erzeugen; und
eine Steuerung (130), die mit dem adaptiven PDN (110) und dem Stromerzeuger (120) verbunden ist, eingerichtet, die Impedanz des adaptiven PDNs (110) gemäß einem Profil des Stroms, der durch den Stromerzeuger (120) erzeugt wird, zu steuern,
**dadurch gekennzeichnet, dass**
die Steuerung (130) eingerichtet ist, sich auf eine Nachschlagtabelle zu beziehen, um die Impedanz des adaptiven PDNs (110) gemäß dem Profil des Stroms, der durch den Stromerzeuger (120) erzeugt wird, einzustellen, wobei die Nachschlagtabelle eine Mehrzahl von Kombinationen der Impedanzen des adaptiven PDNs (110) und der Profile des Stroms, der durch den Stromerzeuger (120) erzeugt wird, und eine Mehrzahl von Jitter-Pegeln, die jeweils zu den Kombinationen korrespondieren, aufweist.

10. Jitter-Steuerungsschaltung (100) gemäß Anspruch 9, **dadurch gekennzeichnet, dass** die Steuerung (130) eingerichtet ist, das adaptive PDN (110) zu steuern, eine unterschiedliche Frequenz bereitzustellen, um die Impedanz des adaptiven PDNs (110) gemäß dem Profil des Stroms, der durch den Stromerzeuger (120) erzeugt wird, einzustellen.

## Revendications

1. Circuit de commande de gigue (100) dans une puce (102), comprenant :
un réseau de distribution d'énergie adaptatif (PDN) (110) configuré pour fournir une tension d'alimentation, capable d'être commandé/modulé pour fournir des différentes impédances ;
un générateur de courant (120), couplé au PDN adaptatif (110), configuré pour recevoir la tension d'alimentation fournie par le PDN adaptatif (110) et pour générer des courants ayant différents motifs ; et
un générateur de gigue (160), couplé au PDN adaptatif (110), configuré pour générer une pluralité de gigues correspondant aux courants ayant différents motifs, respectivement, selon la tension d'alimentation fournie par le PDN adaptatif (110),
**caractérisé en ce que**
pour certains des motifs des courants dont les gigues correspondantes sont supérieures à un seuil, le PDN adaptatif (110) est agencé pour être commandé/modulé pour avoir différentes fréquences afin d'avoir les différentes impédances, respectivement, et
le générateur de gigue (160) est configuré pour générer la pluralité de gigues correspondant aux courants ayant certains des motifs et aux différentes fréquences du PDN adaptatif (110), respectivement, selon la tension d'alimentation fournie par le PDN adaptatif (110),
où une table de consultation est générée sur la base de la pluralité de gigues correspondant aux courants ayant certains des motifs et aux différentes fréquences du PDN adaptatif (110), respectivement, pendant une période hors ligne, et la table de consultation est stockée dans la puce (102), ladite table de consultation comprend une pluralité de combinaisons des impédances du PDN adaptatif (110) et des motifs du courant généré par le générateur de courant (120), et une pluralité de niveaux de gigues correspondant aux combinaisons, respectivement.

2. Circuit de commande de gigue (100) de la revendication 1, **caractérisé en ce que** le PDN adaptatif (110) est agencé pour être commandé/modulé de manière à avoir différentes fréquences afin d'avoir les différentes impédances, respectivement ; et
le générateur de gigue (160) est configuré pour générer la pluralité de gigues correspondant aux courants ayant différents motifs et aux différentes fréquences du PDN adaptatif (110), respectivement, selon la tension d'alimentation fournie par le PDN adaptatif (110).

3. Circuit de commande de gigue (100) de la revendication 1, **caractérisé en ce qu'**il comprend en outre :
un dispositif de commande (130), couplé au générateur de courant (120), configuré pour se référer à une table de consultation pour ajuster l'impédance du PDN adaptatif (110) selon le motif du courant généré par le générateur de courant (120) ou un motif d'un courant généré par un ou plusieurs autre(s) générateur(s) de courant, de manière à abaisser une gigue d'une horloge dans la puce (102).

4. Circuit de commande de gigue (100) de la revendication 1, **caractérisé en ce qu'**il comprend en outre :
un dispositif de commande (130), couplé au générateur de courant (120), configuré pour se référer à une table de consultation pour ajuster l'impédance du PDN adaptatif (110) selon le motif du courant généré par le générateur de courant (120) ou un motif d'un courant généré par un ou plusieurs autre(s) générateur(s) de courant, de manière à abaisser une gigue d'une horloge dans la puce (102);
où la table de consultation comprend une pluralité de combinaisons des impédances du PDN adaptatif (110) et des motifs du courant généré par le générateur de courant (120), et une pluralité de niveaux de gigues correspondant aux combinaisons, respectivement.

5. Procédé de commande de gigue, comprenant le fait :
de fournir un réseau de distribution d'énergie adaptatif (PDN) (110) pour fournir une tension d'alimentation, capable d'être commandé/modulé pour fournir des différentes impédances ;
de recevoir la tension d'alimentation fournie par le PDN adaptatif (110) et générer des courants ayant différents motifs ; et
générer une pluralité de gigues correspondant aux courants ayant différents motifs, respectivement, selon la tension d'alimentation fournie par le PDN adaptatif (110),
**caractérisé par** le fait :
pour certains des motifs des courants dont les gigues correspondantes sont supérieures à un seuil, de commander/moduler le PDN adaptatif (110) de manière à fournir des différentes fréquences pour fournir les différentes impédances, respectivement ;
dans lequel l'étape de génération de la pluralité de gigues comprend la génération de la pluralité de gigues correspondant aux courants ayant certains des motifs et aux différentes fréquences du PDN adaptatif (110), respectivement, selon la tension d'alimentation fournie par le PDN adaptatif (110) ;
de générer une table de consultation basée sur la pluralité de gigues correspondant aux courants ayant certains des motifs et aux différentes fréquences du PDN adaptatif (110), respectivement, pendant une période hors ligne ; ladite table de consultation comprend une pluralité de combinaisons des impédances du PDN adaptatif (110) et des motifs du courant généré par le générateur de courant (120), et une pluralité de niveaux de gigues correspondant aux combinaisons, respectivement ; et
de stocker la table de consultation.

6. Procédé de commande de gigue de la revendication 5, **caractérisé en ce qu'**il comprend en outre le fait :
de commander/moduler le PDN adaptatif (110) de manière à fournir différentes fréquences pour fournir les différentes impédances, respectivement ; et
l'étape de génération de la pluralité de gigues comprend le fait :
de générer la pluralité de gigues correspondant aux courants ayant différents motifs et aux différentes fréquences du PDN adaptatif (110), respectivement, selon la tension d'alimentation fournie par le PDN adaptatif (110).

7. Procédé de commande de gigue de la revendication 5, **caractérisé en ce qu'**il comprend en outre le fait :
de se référer à la table de consultation pour ajuster l'impédance du PDN adaptatif (110) selon le motif du courant ou un motif d'un courant généré par un ou plusieurs autre(s) générateur(s) de courant, de manière à abaisser une gigue d'une horloge dans une puce (102).

8. Procédé de commande de gigue de la revendication 5, **caractérisé en ce qu'**il comprend en outre le fait :
de se référer à une table de consultation pour ajuster l'impédance du PDN adaptatif (110) selon le motif du courant ou un motif d'un courant généré par un ou plusieurs autre(s) générateur(s) de courant, de manière à abaisser une gigue d'une horloge dans une puce (102) ;
dans lequel la table de consultation comprend une pluralité de combinaisons des impédances du PDN adaptatif (110) et des motifs du courant, et une pluralité de niveaux de gigues correspondant aux combinaisons, respectivement.

9. Circuit de commande de gigue (100) dans une puce (102), **caractérisé par** :
un réseau de distribution d'énergie adaptatif (PDN) (110), configuré pour fournir une tension d'alimentation, capable d'être commandé/modulé pour fournir des différentes impédances ;
un générateur de courant (120), couplé au PDN adaptatif (110), configuré pour recevoir la tension d'alimentation fournie par le PDN adaptatif (110) et pour générer un courant ; et
un dispositif de commande (130), couplé au PDN adaptatif (110) et au générateur de courant (120), configuré pour commander l'impédance du PDN adaptatif (110) selon un motif du courant généré par le générateur de courant (120),
**caractérisé en ce que**
le dispositif de commande (130) est configuré pour se référer à une table de consultation afin d'ajuster l'impédance du PDN adaptatif (110) selon le motif du courant généré par le générateur de courant (120), où la table de consultation comprend une pluralité de combinaisons des impédances du PDN adaptatif (110) et des motifs du courant généré par le générateur de courant (120), et une pluralité de niveaux de gigues correspondant aux combinaisons, respectivement.

10. Circuit de commande de gigue (100) selon la revendication 9, **caractérisé en ce que** le dispositif de commande (130) est configuré pour commander le PDN adaptatif (110) de manière à fournir une différente fréquence pour ajuster l'impédance du PDN adaptatif (110) selon le motif du courant généré par le générateur de courant (120).
